## Europäisches Patentamt
## European Patent Office
## Office européen des brevets

(19)

(11) Veröffentlichungsnummer: **0 207 086**
**B1**

(12) # EUROPÄISCHE PATENTSCHRIFT

(45) Veröffentlichungstag der Patentschrift:
23.08.89

(21) Anmeldenummer: 85905505.5

(22) Anmeldetag: 30.10.85

(86) Internationale Anmeldenummer:
PCT/DE 85/00430

(87) Internationale Veröffentlichungsnummer:
WO 86/03860 (03.07.86 Gazette 86/14)

(51) Int. Cl.⁴: **G 06 F 1/00**, G 05 F 1/571,
G 01 R 19/165

(54) **SCHALTUNGSANORDNUNG ZUR ÜBERWACHUNG DER STROMVERSORGUNG EINES ELEKTRISCHEN VERBRAUCHERS.**

(30) Priorität: 18.12.84 DE 3446129

(43) Veröffentlichungstag der Anmeldung:
07.01.87 Patentblatt 87/2

(45) Bekanntmachung des Hinweises auf die Patenterteilung:
23.08.89 Patentblatt 89/34

(84) Benannte Vertragsstaaten:
CH DE FR GB IT LI

(56) Entgegenhaltungen:
US-A-4 428 020

Patents Abstracts of Japan, Band 8, Nr. 159 (P-286)(1596), 24. Juli 1983 & JP-A-5957316
Patents Abstracts of Japan, Band 7, Nr.152 (P-208)(1297), 5. Juli 1983 & JP-A-5862719
Patents Abstracts of Japan, Band 7, Nr. 164 (P-211)(1309), 19. Juli 1983 & JP-A-5872219

(73) Patentinhaber: ROBERT BOSCH GMBH, Postfach 50, D-7000 Stuttgart 1 (DE)

(72) Erfinder: FAUSER, Edwin, Justinus- Kerner-Strasse 8, D-7257 Ditzingen (DE)
Erfinder: LIST, Hans, Bohrainstrasse 20, D-7530 Pforzheim (DE)

**Beschreibung**

**Stand der Technik**

Die Erfindung betrifft eine Schaltungsanordnung zur Überwachung der Stromversorgung eines elektrischen Verbrauchers, insbesondere eines Mikrocomputers auf einem mobilen Datenträger mit induktiver Energieübertragung, nach der Gattung des Anspruchs 1.

Bei mobilen Datenträgern, wie sie von in automatischen Transferstraßen oder Montagebändern umlaufenden Werkstückträgern gebildet werden, wird die Versorgungsenergie für die auf dem Datenträger angeordneten Schaltkreise von längs den Transferstraßen oder Montagebändern aufgestellten Bearbeitungs- und Steuerstationen aus induktiv übertragen, und zwar durch zeitweilige induktive Kopplung von in der Feststation und auf dem Datenträger vorhandenen Übertragerspulen im Moment des Durchlaufens des Datenträgers durch die Feststation. Dabei ergibt sich für den Datenträger eine Betriebsspannung, die von vielen Größen, z. B. vom Abstand der Übertragerspulen von Datenträger und Feststation, von der Geschwindigkeit des Datenträgers u. dgl., abhängt und deshalb in weiten Grenzen variiert. Der auf dem Datenträger vorhandene Mikrocomputer zur Steuerung der Datenübertragung zwischen Feststation und Datenträger sowie zur Datenverarbeitung im Datenträger bedarf aber einer konstanten Versorgungsspannung, so daß er spannungsabhängig ein- bzw. abgeschaltet werden muß, wobei eine genaue Power-up- und Power-down-Sequenz einzuhalten ist.

Aus US-A-4 428 020 ist eine Überwachungsschaltung für eine Stromversorgung bekannt, die zwei Komparatoren und ein UND-Gatter enthält, an dessen Eingänge die Ausgänge der beiden Komparatoren geschaltet sind. Ein erster Komparator überwacht eine erforderliche Spannungsdifferenz zwischen Eingangsspannung und Ausgangsspannung an einem Spannungsregler. Diese Maßnahme ist für einen sicheren Überwachungsbetrieb nicht ausreichend, da die erforderliche Mindestspannungsdifferenz auch dann auftreten kann, wenn die Eingangsspannung für einen ordnungsgemäßen Betrieb des Spannungsreglers noch zu gering ist. Es ist deshalb ein zweiter Komparator vorgesehen, der die Eingangsspannung auf einen bestimmten Mindestwert hin überwacht. Die am Spannungsregler angeschlossene Datenverarbeitungsanlage wird nur dann in Betrieb gesetzt, wenn beide Komparatoren signalisieren, daß ein störungsfreier Betrieb möglich ist.

Aufgabe der Erfindung ist es, eine Schaltungsanordnung zur Überwachung der Stromversorgung eines elektrischen Verbrauchers anzugeben, die mit einfachen Mitteln das Einschaltsignal für den Stromverbraucher exakt beim Erreichen der stabilisierten Versorgungsspannung und keinesfalls vorher auslöst und die beim Absinken der unstabilisierten Versorgungsspannung rechtzeitig vor Erreichen einer undefinierten Versorgungsspannung ein Abschaltsignal für den Stromverbraucher abgibt. Toleranzen des Spannungsreglers, die Stromaufnahme des elektrischen Verbrauchers und die Anstiegs- bzw. Abfallgeschwindigkeit der Betriebsspannung sollen keinen Einfluß auf die Funktion der Schaltung haben.

**Vorteile der Erfindung**

Die erfindungsgemäße Schaltungsanordnung mit den kennzeichnenden Merkmalen des Anspruchs 1 hat den Vorteil, daß das Einschaltsignal für den Verbraucher exakt beim Erreichen der stabilisierten Spannung und keinesfalls vorher ausgelöst wird und daß beim Abschalten die Leistungsreserven voll ausgeschöpft werden, indem das Abschaltsignal für den Stromverbraucher dann ausgelöst wird, wenn der Strom gerade noch ausreicht, den Verbraucher mit konstanter Spannung zu versorgen.

Die Toleranzen des Spannungsreglers, die Stromaufnahme des Verbrauchers und die Anstiegs- bzw. Abfallgeschwindigkeit der unstabilisierten Eingangsspannung haben auf die Funktion der Schaltung keinen Einfluß.

Durch die Abnahme der Referenzspannung am Reglerausgang ist die Stabilität der Referenzspannung sichergestellt.

Vorteilhafte Ausführungsformen der Erfindung ergeben sich aus den weiteren Ansprüchen 2 bis 8.

Eine vorteilhafte Ausführungsform der Erfindung ergibt sich dabei aus Anspruch 6. Durch diese Maßnahme wird dem Komparator eine Hysterese verliehen die den Einfluß von Lastschwankungen, bedingt durch unterschiedliche Stromaufnahme des Verbrauchers, unterdrückt.

**Zeichnung**

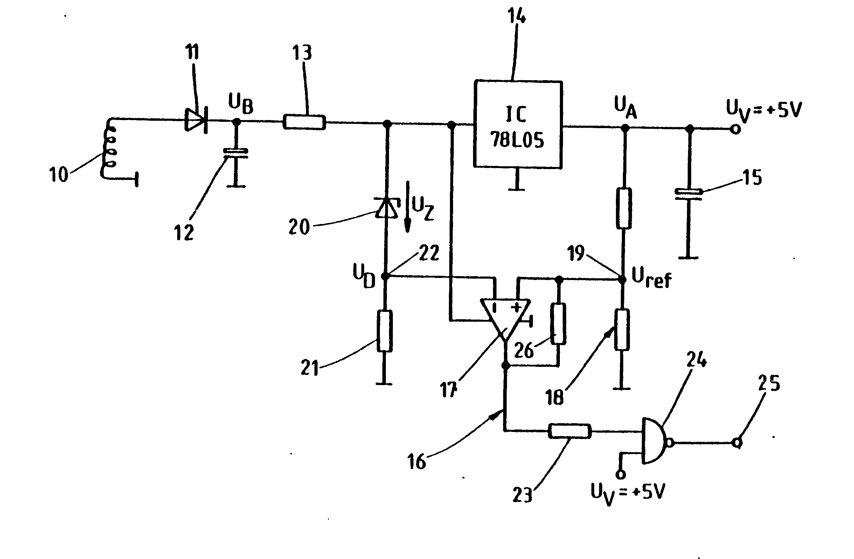

Die Erfindung ist anhand eines in der Zeichnung dargestellten Ausführungsbeispiels in der nachfolgenden Beschreibung näher erläutert. Dabei zeigt die Zeichnung eine in einem mobilen Datenträger integrierte Schaltungsanordnung zur Überwachung der Stromversorgung eines elektronischen Verbrauchers, insbesondere eines Mikrocomputers.

**Beschreibung des Ausführungsbeispiels**

Die im Schaltbild dargestellte Schaltungsanordnung zur Überwachung der Stromversorgung eines elektrischen Verbrauchers, hier eines nicht weiter dargestellten Mikrocomputers, ist auf einem mobilen Datenträger mit induktiver Energieübertragung untergebracht. Solche Datenträger werden auf Werkstückträgern angeordnet, die auf einem Transport oder Montageband eine automatische Transferstraße durchlaufen, wobei die Datenträger mit fest aufgestellten Verarbeitungs- oder Steuerstationen kommunizieren und automatische Verarbeitungs- oder Steueroder Transportbefehle auslösen. Eine solche Transferstraße ist z. B. in der DE-OS-3 331 694 ausführlich beschrieben. Wie dort auch ausgeführt ist, erfolgt die Energieversorgung des Datenträgers von der Feststation aus, und zwar während des Durchlaufs des Datenträgers durch die Feststation und dadurch bedingter induktiver Kopplung, die dadurch erreicht wird, daß eine auf dem Datenträger angeordnete Übertragerspule 10 an einer in der Feststation angeordneten und mit einer Stromquelle verbundenen Übertragerspule vorbeigeführt wird. Die Übertragerspule 10, der die Reihenschaltung aus einer Diode 11 und einem Kondensator 12 parallel geschaltet ist, liefert während der Zeitspanne der induktiven Kopplung mit der Übertragerspule der Feststation eine zeitveränderliche Betriebsspannung $U_B$, die am Ausgang des Kondensators 12 abgegriffen und über einen Widerstand 13 einem Spannungsregler 14 zugeführt ist. Der als integrierter Schaltkreis IC 78 L 05 ausgebildete Spannungsregler 14 dient zum Erzeugen einer für eine vorgegebene Zeitspanne annähernd konstanten Versorgungsspannung $U_V$ von hier +5 V für den Mikrocomputer und weiterer Schaltkreisen, die an einem dem Reglerausgang parallel geschalteten zweiten Kondensator 15 abnehmbar ist. Da der Spannungsregler 14 eine solche konstante Versorgungsspannung $U_V$ nur dann ausregeln kann, wenn eine bestimmte Mindestspannung an seinem Eingang liegt, die Betriebsspannung $U_B$ der Schaltungsanordnung aber bei jedem Durchlauf einer Feststation von Null aus anwächst und wieder auf Null absinkt, ist ein Spannungsüberwacher 16 vorgesehen, der den Stromverbraucher, hier in Form eines Mikrocomputers, nur während der Zeitspanne einschaltet, in welcher die Versorgungsspannung $U_V$ konstant 5 V beträgt. Diese Zeitspanne ist festgelegt durch den Zeitpunkt des Anstiegs der Reglerausgangsspannung $U_A$ auf die konstante Versorgungsspannung $U_V$ und vor Absinken der Reglerausgangsspannung $U_A$ unter die konstante Versorgungsspannung von 5 V. Hierzu weist der Spannungsüberwacher 16 einen Komparator 17 auf, an dessen einem Eingang eine der Reglerausgangsspannung $U_A$ proportionale Referenzspannung $U_{ref}$ und an dessen anderem Eingang eine am Reglereingang abgenommene, einen Schwellwert übersteigende Differenzspannung $U_D$ anliegt. Zur Gewinnung der Referenzspannung $U_{ref}$ ist dem Reglerausgang $U_A$ ein Spannungsteiler 18 parallel geschaltet, dessen Spannungsabgriff 19 mit dem nichtinvertierenden Eingang des Komparators 17 verbunden ist. Zur Ableitung der Differenzspannung $U_D$ ist dem Reglereingang eine Reihenschaltung aus einer Zenerdiode 20 und einem Widerstand 21 parallel geschaltet und der Verbindungspunkt 22 von Zenerdiodenausgang und Widerstand 21 an dem invertierenden Eingang des Komparators 17 angeschlossen. Der am Widerstand 21 auftretende Spannungsabfall ist ein Maß für die Differenzspannung $U_D$. Die Zenerspannung $U_Z$ von hier 7,5 V ist größer zu wählen als die Versorgungsspannung $U_V$ von 5 V aber nicht zu groß, so daß sichergestellt ist, daß nach Aufladung des Kondensators 15 - also wenn der dem Spannungsregler 14 zugeführte Strom größer wird als der am Ausgang des Spannungsreglers abgenommene - die Spannung am Eingang des Spannungsreglers 14 auf die Zenerspannung anwächst, und damit der überschüssige Strom über die Zenerdiode 20 abfließt und am Widerstand 21 die Differenzspannung $U_D$ generiert.

Am Ausgang des Komparators 17 ist über einen Widerstand 23 der eine Eingang eines NAND-Gatters 24 angeschlossen, dessen anderer Eingang mit der Versorgungsspannung $U_V$ von 5 V belegt ist. Am Ausgang 25 des NAND-Gatters 24 ist ein Einschaltsignal logisch 1 für den Verbraucher und ein Abschaltsignal logisch 0 für den Verbraucher abnehmbar. Der Ausgang des Komparators 17 ist noch über einen Koppelwiderstand 26 mit dem nichtinvertierenden Eingang des Komparators 17 verbunden. Durch diese Rückkopplung wird eine Schalthysterese hergestellt, wodurch der Einfluß von Lastschwankungen unterdrückt wird.

Die Funktionsweise der Schaltungsanordnung ist wie folgt:

Durchläuft der Datenträger eine Feststation und wird dabei die Übertragerspule 10 mit einer stromversorgten Übertragerspule in der Feststation zeitweilig induktiv gekoppelt, so steigt die Betriebsspannung $U_B$ am Ausgang des Kondensators 12 langsam an. Da die Zenerdiode 20 noch gesperrt ist, steigt auch die an der Zenerdiode 20 liegende Spannung $U_Z$ an. Der Spannungsregler 14 schaltet die Spannung $U_Z$ voll auf den Reglerausgang durch, so daß die Ausgangsspannung $U_A$ des Spannungsreglers 14 ebenfalls ansteigt. Die am Widerstand 21 abfallende Differenzspannung $U_D$ ist Null, während die Referenzspannung $U_{ref}$ einen positiven Wert annimmt, so daß der Ausgang des Komparators 17 positiv wird. Der Ausgang 25 des NAND-Gatters 24 nimmt logisch 0 an. Solange hier das Ausschaltsignal logisch 0 ansteht, bleibt der Stromverbraucher, hier Mikrocomputer, ausgeschaltet.

Mit Ansteigen der Reglerausgangsspannung $U_A$ wird auch der Kondensator 15 geladen, wodurch der Strom durch den Spannungsregler 14 zunächst größer ist als der spätere Betriebsstrom. Erreicht die Reglerausgangsspannung $U_A$ die konstante Versorgungsspannung $U_V$ = 5 v, muß dem Kondensator 15 keine weitere Ladung zugeführt werden, und der Spannungsregler 14 nimmt den Strom sofort zurück, wodurch die Spannung $U_Z$ sprunghaft ansteigt. Die Zenerdiode 20 wird leitfähig und übernimmt den überschüssigen Strom. Dadurch steigt die am Widerstand 21 abfallende Differenzspannung $U_D$ rasch an. Sobald die Differenzspannung $U_D$, die nunmehr konstante Referenzspannung $U_{ref}$ übersteigt, nimmt der Ausgang des Komparators 17 logisch 0 an, und der Ausgang 25 des NAND-Gatters 24 kippt auf logisch 1. Der Stromverbraucher, hier Mikrocomputer, wird eingeschaltet und sein Aktivierungszustand wird solange beibehalten, wie der Ausgang 25 des NAND-Gatters 24 logisch 1 beibehält.

Wird die induktive Kopplung der Übertragerspule 10 mit der Übertragerspule der Feststation aufgehoben, so sinkt zuerst die Betriebsspannung $U_B$ am Kondensator 12 soweit ab, bis der Strom in der Zenerdiode 20 gegen Null geht. Zu diesem Zeitpunkt reicht die Energie noch aus, um die Versorgungsspannung $U_V$ von 5 V aufrecht zu erhalten. Die Spannung $U_D$ am Widerstand 21 sinkt unter die Referenzspannung $U_{ref}$ ab und der Ausgang des Komparators 17 wird wieder positiv. Damit kippt der Ausgang 25 des NAND-Gatters 24 auf logisch 0 und der Verbraucher wird abgeschaltet, und zwar solange, bis bei der nächsten Einschaltung der Betriebsspannung $U_B$ der Ausgang 25 des NAND-Gatters 24 wie beschrieben wieder auf logisch 1 umkippt.

**Patentansprüche**

1. Schaltungsanordnung zur Überwachung der Stromversorgung eines elektrischen Verbrauchers, insbesondere eines Mikrocomputers auf einem mobilen Datenträger mit induktiver Energieübertragung, mit einem an einer zeitveränderlichen Betriebsspannung angeschlossenen Spannungsregler (14) zum Erzeugen einer annähernd konstanten Versorgungsspannung für den Verbraucher und mit einem Spannungsüberwacher (16) zum Ein- und Abschalten des Verbrauchers nach Anstieg der Reglerausgangsspannung auf und vor Absinken der Reglerausgangsspannung unter die Versorgungsspannung, wobei der Spannungsüberwacher einen Komparator (17) enthält, der an seinem Ausgang das Ein- und Abschaltsignal für den Verbraucher liefert, dadurch gekennzeichnet, daß an einem Eingang des Komparators (17) eine der Reglerausgangsspannung ($U_A$) proportionale Referenzspannung ($U_{ref}$) und am anderen Eingang des Komparators (17) eine am Reglereingang abgenommene, einen Schwellwert übersteigende Differenzspannung ($U_D$) anliegt, und daß der Schwellwert derart gewählt ist, daß die Differenzspannung ($U_D$) die Referenzspannung ($U_{ref}$) dann über- bzw. unterschreitet, wenn die Reglerausgangsspannung ($U_A$) die Versorgungsspannung ($U_V$) erreicht bzw. noch nicht unterschritten hat.

2. Schaltungsanordnung nach Anspruch 1, dadurch gekennzeichnet, daß dem Reglerausgang ein Kondensator (15) parallel geschaltet ist und daß die Referenzspannung ($U_{ref}$) an einem dem Kondensator (15) parallel liegenden Spannungsteiler (18) abgegriffen ist.

3. Schaltungsanordnung nach Anspruch 1 oder 2, dadurch gekennzeichnet, daß dem Reglereingang eine Reihenschaltung aus einer Zenerdiode (20) und einem Widerstand (21) parallel geschaltet ist, wobei die Zenerdiode (20) am Eingang des Spannungsreglers (14) angeschlossen ist, und daß die Differenzspannung ($U_D$) als Spannungsabfall am Widerstand (21) abgegriffen ist.

4. Schaltungsanordnung nach Anspruch 2 und 3, dadurch gekennzeichnet, daß der Spannungsabgriff (19) des Spannungsteilers (18) mit dem nichtinvertierenden Eingang und der Verbindungspunkt (22) von Zenerdiodenausgang und Widerstand (21) mit dem invertierenden Eingang des Komparators (17) verbunden ist.

5. Schaltungsanordnung nach einem der Ansprüche 1 - 4, dadurch gekennzeichnet, daß der Ausgang des Komparators (17) an dem einen Eingang eines NAND-Gatters (24) angeschlossen ist, dessen anderer Eingang mit der Versorgungsspannung ($U_V$) belegt ist und an dessen Ausgang (25) das Einschaltsignal für den Verbraucher als logisch 1-Signal und das Abschaltsignal als logisch 0-Signal ansteht.

6. Schaltungsanordnung nach Anspruch 4 oder 5, dadurch gekennzeichnet, daß der Ausgang des Komparators (17) über einen Koppelwiderstand (26) mit dem nichtinvertierenden Eingang des Komparators (17) verbunden ist.

7. Schaltungsanordnung nach einem der Ansprüche 1 - 6, dadurch gekennzeichnet, daß die Betriebsspannung für den Komparator (17) am Reglereingang abgegriffen ist.

8. Schaltungsanordnung nach einem der Ansprüche 3 - 7, dadurch gekennzeichnet, daß die Zenerspannung ($U_Z$) der Zenerdiode (20) wenig größer gewählt ist als die Versorgungsspannung ($U_V$).

**Claims**

1. Circuit arrangement for monitoring the electric current supply of an electric consumer, particularly of a microcomputer on a mobile data carrier with inductive energy transmission, with a voltage regulator (14), which is connected to a time-variable operating voltage, for generating an approximately constant supply voltage for the consumer, and with a voltage monitor (16) for switching the consumer on and off after the regulator output voltage rises to, and before the regulator output voltage drops below, the supply voltage, the voltage monitor containing a comparator (17) which supplies the switch-on and -off signal for the consumer at its output, characterised in that a reference voltage ($U_{ref}$) proportional to the regulator output voltage ($U_A$) is present at one input of the comparator (17), and a difference voltage ($U_D$), which is picked up at the regulator input and exceeds a threshold value, is present at the other input of the comparator (17), and that the threshold value is selected in such a manner that the difference voltage ($U_D$) exceeds or drops below the reference voltage ($U_{ref}$) when the regulator output voltage ($U_A$) has reached, or has not yet dropped below, the supply voltage ($U_V$).

2. Circuit arrangement, according to Claim 1, characterized in that the regulator output is connected in parallel with a capacitor (15), and that the reference voltage ($U_{ref}$) is picked up at a voltage divider (18) which is in parallel with the capacitor (15).

3. Circuit arrangement, according to Claim 1 or 2, characterized in that a regulator input is connected in parallel with a series circuit of a Zener diode (20) and a resistor (21), the Zener diode (20) being connected to the input of the voltage regulator (14), and that the difference voltage ($U_D$) is picked up as voltage drop across the resistor (21).

4. Circuit arrangement, according to Claim 2 and 3, characterized in that the voltage tap (19) of the voltage divider (18) is connected to the non-inverting input, and the junction (22) of the Zener diode output and resistor (21) is connected to the inverting input of the comparator (17).

5. Circuit arrangement, according to one of the Claims 1 to 4, characterized in that the output of the comparator (17) is connected to one input of a NAND gate (24), to the other input of which the supply voltage ($U_V$) is applied, and at the output (25) of which the switch-on signal for the consumer is present as a logical 1 signal, and the switch-off signal is present as a logical 0 signal.

6. Circuit arrangement, according to Claim 4 or 5, characterized in that the output of the comparator (17) is connected via a coupling resistor (26) to the non-inverting input of the comparator (17).

7. Circuit arrangement, according to one of Claims 1 - 6, characterized in that the operating voltage for the comparator (17) is picked up at the regulator input.

8. Circuit arrangement, according to one of Claims 3 - 7, characterized in that the Zener voltage ($U_Z$) of the Zener diode (20) is selected to be slightly greater than the supply voltage ($U_V$).

## Revendications

1. Circuit pour la surveillance de l'alimentation en courant d'un consommateur de courant électrique, notamment d'un microcalculateur sur un support de données mobile avec une transmission inductive de l'énergie, avec un régulateur de tension (14) raccordé à une tension de fonctionnement variable dans le temps, pour obtenir une tension d'alimentation approximativement constante pour le consommateur de courant électrique, et avec un dispositif de surveillance de la tension (16) pour mettre en circuit et hors circuit le consommateur de courant électrique après que la tension de sortie du régulateur ait augmenté, et avant que la tension de sortie du régulateur s'abaisse au-dessous de la tension d'alimentation, le dispositif de surveillance de la tension comprenant un comparateur (17) qui délivre à sa sortie le signal de mise en circuit et hors circuit pour le consommateur de courant électrique, circuit caractérisé en ce qu'à l'entrée du comparateur (17) est appliquée une tension de référence ($U_{ref}$) proportionnelle à la tension de sortie du régulateur ($U_A$), tandis qu'à l'autre entrée du comparateur (17) est appliquée une tension différentielle ($U_D$) prélevée à l'entrée du régulateur et dépassant une valeur de seuil, cette valeur de seuil étant choisie de façon que la tension différentielle ($U_D$) franchisse alors vers le haut ou bien vers le bas la tension de référence ($U_{ref}$) lorsque la tension de sortie du régulateur ($U_A$) atteint la tension d'alimentation ($U_V$) ou bien ne l'a pas encore franchie vers le bas.

2. Circuit selon la revendication 1, caractérisé en ce qu'un condensateur (15) est branche en parallèle à la sortie du régulateur et la tension de référence ($U_{ref}$) est prélevée sur un diviseur de tension (18) placé en parallèle sur le condensateur (15).

3. Circuit selon la revendication 1 ou 2, caractérisé en ce qu'un montage en série constitué d'une diode de Zener (20) et d'une résistance (21) est branché en parallèle à l'entrée du régulateur, la diode de Zener (20) étant raccordée à l'entrée du régulateur de tension (14) tandis que la tension différentielle ($U_D$) est prélevée sous la forme de chute de tension sur la résistance (21).

4. Circuit selon les revendications 2 et 3, caractérisé en ce que la prise de tension (19) du diviseur de tension (18) est reliée à l'entrée non inversée du comparateur (17), tandis que le point de jonction (22) de la sortie de la diode de Zener et de la résistance (21) est relié à l'entrée inversée de ce comparateur (17).

5. Circuit selon une des revendications 1 à 4, caractérisé en ce que la sortie du comparateur (17) est raccordée à l'une des entrées d'une porte NON-ET (24), à l'autre entrée de laquelle est appliquée la tension d'alimentation ($U_V$), et à la sortie de laquelle le signal de mise en circuit pour le consommateur de courant électrique, est présent sous la forme de signal logique 1, tandis que le signal de mise hors circuit est présent sous la forme de signal logique 0.

6. Circuit selon la revendication 4 ou 5, caractérisé en ce que la sortie du comparateur (17) est reliée par l'intermédiaire d'une résistance de couplage (26) à l'entrée non inversée de ce comparateur (17).

7. Circuit selon une des revendications 1 à 6, caractérisé en ce que la tension de fonctionnement du comparateur (17) est prélevée à l'entrée du régulateur.

8. Circuit selon une des revendications 3 à 7, caractérisé en ce que la tension Zener ($U_Z$) de la diode de Zener (20) est choisie inférieure à la tension d'alimentation ($U_V$).

$U_V = +5V$

15

$U_A$

$U_{ref}$

14

IC 78L05

19

18

26

17

24

25

$U_V = +5V$

23

16

$U_Z$

22

$U_D$

13

$U_B$

11

12

20

21

10

1